# EUROPEAN PATENT APPLICATION

(11) **EP 4 528 803 A1**
(43) Date of publication of application: **26.03.2025**
(21) Application number: 23807619.4
(22) Date of filing: 15.05.2023
(51) Int. Cl.: H01L 23/473, H05K 7/20

(54) **COOLING STRUCTURE AND STRUCTURE**

(30) Priority: 16.05.2022 JP 2022080412
(71) Applicant: Resonac Corporation, Tokyo 105-7325 (JP)
(72) Inventor: FUKUKAWA, Yuji, Tokyo 105-8518 (JP); YAMASHITA, Takahiro, Tokyo 105-8518 (JP); ITO, Seiichi, Tokyo 105-8518 (JP); SHODA, Hiroaki, Tokyo 105-8518 (JP)
(74) Representative: Berggren Oy
(86) International application number: PCT/JP2023/018178
(87) International publication number: WO 2023/224017

(57) **Abstract**

A cooling structure includes an outer packaging material with an inlet and an outlet for a refrigerant. The outer packaging material includes a metal layer, and a resin layer provided on at least one surface of the metal layer, and the cooling structure includes a conductive portion that conducts in a thickness direction of the cooling structure, and a periphery of the conductive portion is insulated.

## Description

### Technical field

The present disclosure relates to a cooling structure, and a structure.

### Background Art

In the field of electronic devices such as smartphones and personal computers, and battery modules mounted on electric vehicles, hybrid vehicles and the like, techniques for incorporating water-cooling devices, heat pipes and the like as heat generation countermeasures are known. Also, in power semiconductor modules made of silicon carbide or the like, measures using cooling plates, heat sinks or the like as heat generation countermeasures have been proposed.

For example, vehicles equipped with motors such as hybrid cars and electric cars, are equipped with a driving means for driving the motor. The driving means is composed of a power module having a plural power semiconductor such as an IGBT (Insulated Gate Bipolar Transistor), an electronic component such as a capacitor, and a bus bar that electrically connect these electronic components. When driving a motor, a large current may flow through the bus bar that connects the power semiconductors, capacitors and the like. In this case, the driving means generates heat due to switching loss, resistance loss and the like, and therefore it is desirable to efficiently cool the driving means. It is also desirable to efficiently cool the heat generated by the battery module installed in the vehicle.

A cooling structure may be a structure made of a metal with high thermal conductivity, such as an aluminum cooling fin core structure. However, since it is made of metal, it is heavy, and since it needs to be attached to an object to be cooled by welding or the like, it needs to be a certain thickness, which makes it difficult to make it thin.

Therefore, from the viewpoint of reducing weight, and the like, a cooling structure has been proposed in which an outer packaging material and an inner core material are made of a laminate material in which a metal heat transfer layer is laminated with resin layer, and a refrigerant is circulated through a flow path separated by the inner core material (see, for example, Patent Document 1). It is described that a heat exchanger of Patent Document 1 can be sufficiently thinned because it is produced by heat fusing laminate materials having a heat fusion layer. Furthermore, in the heat exchanger described in Patent Document 1, the shape and size of the laminated materials that serve as the exterior material and the inner core material can be easily changed, which is said to increase design freedom and improve versatility.

### Related Art Documents

### Patent Documents

Patent Document 1: Japanese Patent Application Laid-Open (JP-A) No. 2020-3132

### SUMMARY OF INVENTION

Although the heat exchanger described in Patent Document 1 is lightweight and easy to handle, the outer packaging material has a resin layer, which may limit the placement position. In view of such circumstances, the present disclosure relates to providing a cooling structure and a structure that are lightweight and have a high degree of freedom in placement position.

### Solution to Problem

Means for solving the above problems include the following embodiments.
<1> A cooling structure including an outer packaging material with an inlet and an outlet for a refrigerant,
   in which the outer packaging material includes a metal layer, and a resin layer provided on at least one surface of the metal layer, and
   in which the cooling structure includes a conductive portion that conducts in a thickness direction of the cooling structure, and a periphery of the conductive portion is insulated.
<2> The cooling structure according to <1>, in which the conductive portion includes an elastic structure.
<3> The cooling structure according to <1> or <2>, in which at least a part of the conductive portion is made of metal.
<4> The cooling structure according to any one of <1> to <3>, further including an inner core material provided inside the outer packaging material.
<5> The cooling structure according to <4>, in which the inner core material has a concave and convex shape that divide a flow path of the refrigerant into multiple parts.
<6> The cooling structure according to <4> or <5>, in which the inner core material includes a metal layer, and resin layers provided on both sides of the metal layer.
<7> A structure including the cooling structure according to any one of <1> to <6> and an object to be cooled provided on the cooling structure.

### Advantageous Effects of Invention

According to the present disclosure, it is possible to provide a cooling structure and a structure that are lightweight and have a high degree of freedom in placement position.

### BRIEF DESCRIPTION OF DRAWINGS

FIG. 1 is a schematic perspective view showing an appearance of a cooling structure 100 of one embodiment in the present disclosure.
FIG. 2 is an exploded view of the cooling structure 100 of FIG. 1, separated into its individual components.
FIG. 3 is a schematic perspective view of a portion of an inner core material 40 in one embodiment in the present disclosure.
FIG. 4 is a schematic perspective view showing an example of a conductive portion 50.
FIG. 5 is a schematic perspective view of an inner core material 40 in another embodiment in the present disclosure.
FIG. 6 is a schematic perspective view illustrating a modified example of the cooling structure, showing an interior in a case in which an upper outer packaging material 30B is removed.

### DESCRIPTION OF EMBODIMENTS

Hereinafter, embodiments in the present disclosure will be described in detail. It is to be noted, however, that the present disclosure is not limited to the following embodiments. In the embodiments described below, components thereof (including element steps and the like) are not essential, unless otherwise specified. The same applies to numerical values and ranges thereof, and the present disclosure is not limited thereto.

In a case in which the embodiments in the present disclosure are described with reference to the drawings, a configuration of embodiments is not limited to the configuration shown in the drawings. Furthermore, the sizes of the members in each figure are conceptual, and the relative size relationships between the members are not limited thereto. Further, in each drawing, members having substantially the same function are given the same reference numerals in all drawings, and duplicated explanations will be omitted.

In the present disclosure, the term "layer" comprehends herein not only a case in which the layer is formed over the whole observed region where the layer is present, but also a case in which the layer is formed only on part of the region.

In the present disclosure, the term "laminate" refers to stacking layers, and two or more layers may be joined, or two or more layers may be detachable.

### <Cooling structure>

A cooling structure in the present disclosure includes an outer packaging material with an inlet and an outlet for a refrigerant, in which the outer packaging material includes a metal layer, and a resin layer provided on at least one surface of the metal layer, and the cooling structure includes a conductive portion that conducts in a thickness direction of the cooling structure, and a periphery of the conductive portion is insulated.

In the conventional cooling structure described in Patent Document 1, in a case in which it is desired to conduct electricity between objects to be cooled arranged on both sides of the cooling structure, the cooling structure must be positioned to avoid the area where electric conduction is required, since the outer packaging material has a resin layer. Alternatively, it is necessary to install conductive wiring in a detouring manner around the cooling structure. In contrast, the cooling structure in the present disclosure can be positioned in places where electric conduction is required, so there is a high degree of freedom in the placement position. In addition, since the cooling structure in the present disclosure uses the outer packaging material composed of a metal layer and a resin layer, the weight is reduced.

A position of the conductive portion in the cooling structure is not particularly limited. A number of conductive portions in the cooling structure is not particularly limited. For example, the cooling structure may be designed to arrange the conductive portion according to the locations where the electric conduction is required, or the conductive portion may be provided in advance in the cooling structure, and the location of the conductive portion may be aligned with a planned electric conduction of an object to be cooled or the like. In the latter case, providing multiple conductive portions in the cooling structure results in a cooling structure with a higher degree of freedom in terms of the location.

Hereinafter, the cooling structure in the present disclosure will be described with reference to the drawings. Note that the embodiments in the present disclosure are not limited to the aspects shown in the drawings.

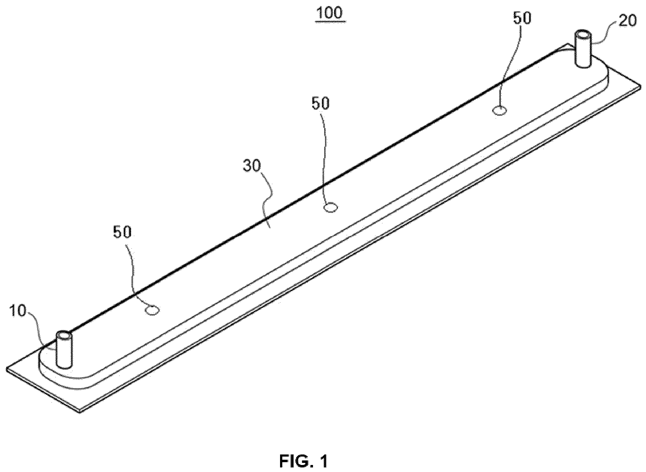

FIG. 1 is a schematic perspective view showing an appearance of a cooling structure 100 of one embodiment in the present disclosure. The cooling structure 100 shown in FIG. 1 has an inlet 10 and an outlet 20 for a refrigerant, and is entirely covered with an outer packaging material 30. The cooling structure 100 has conductive portions 50 that conduct electricity in a thickness direction.

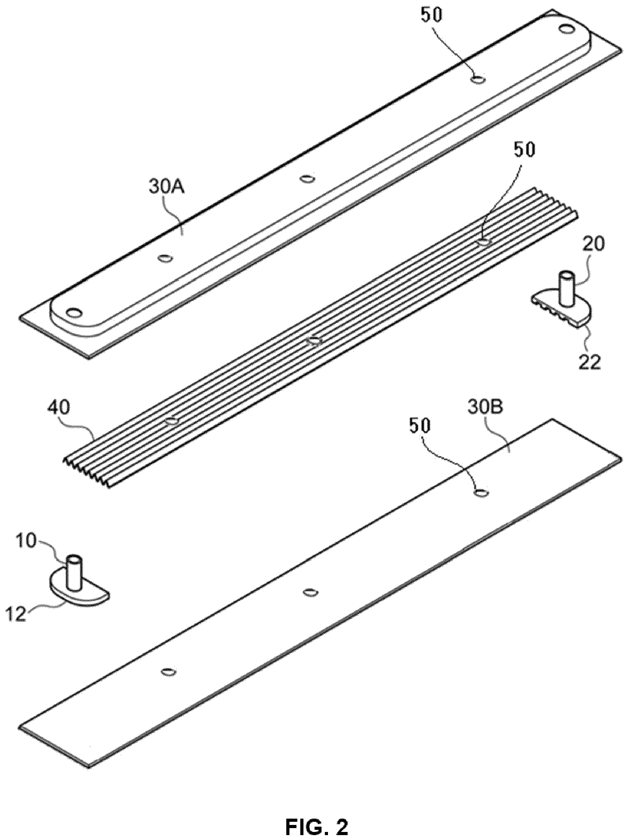

FIG. 2 is an exploded view of the cooling structure 100 of FIG. 1, separated into its individual components.

The outer packaging material 30 is composed of an upper outer packaging material 30A and a lower outer packaging material 30B. In the present disclosure, the upper and lower are written according to a top and bottom in the drawings, but the top and bottom may be reversed.

The upper outer packaging material 30A is provided with holes for passing through a joint pipe as the inlet 10 and a joint pipe as the outlet 20. From the viewpoint of fixing the joint pipes and assembling, it is preferable that the joint pipe of the inlet 10 is provided as a part of a header part 12, and the joint pipe of the outlet 20 is provided as a part of a footer part 22. The joint pipe of the inlet 10 may be molded integrally with the header part 12, and the joint pipe of the outlet 20 may be molded integrally with the footer part 22.

In the cooling structure 100 of FIGs 1 and 2, the joint pipes extends outward in a thickness direction of the cooling structure 100, but the orientation of the joint pipes are not limited to this. For example, the joint pipes may extend outward in a surface direction of the cooling structure 100. Alternatively, the joint pipe of the inlet 10 and the joint pipe of the outlet 20 may be oriented in different directions.

An inner core material 40 is disposed inside the outer packaging material 30. The inner core material 40 divides the flow path of the refrigerant flowing from the header part 12 to the footer part 22 into multiple parts. A periphery of the upper outer packaging material 30A and the lower outer packaging material 30B are closed to seal. Since the upper outer packaging material 30A and the outer packaging material 30B have a resin layer, the periphery of the upper lower outer packaging material 30B and the lower outer packaging material 30A can be closed and sealed by fusing the resin layer.

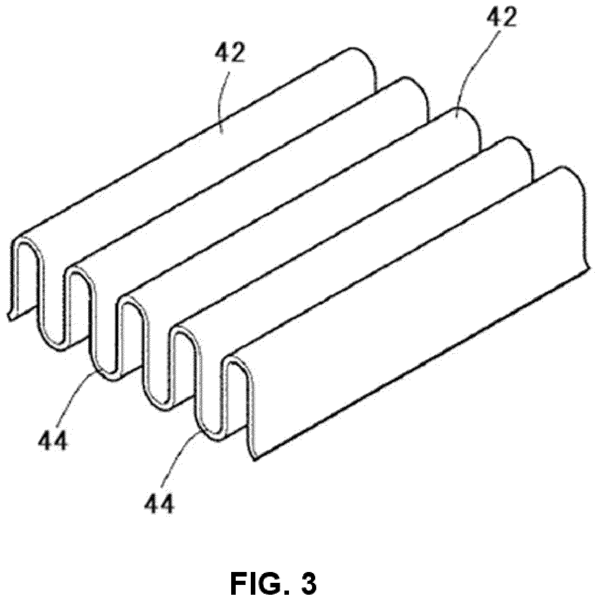

FIG. 3 is a schematic perspective view of a portion of an inner core material 40 in one embodiment in the present disclosure. The inner core material 40 has a concave and convex shape that divide a flow path of a refrigerant into multiple parts, and has multiple convex portions 42 and multiple concave portions 44.

The outer packaging materials 30A and 30B and the inner core material 40 are provided with holes for forming the conductive portion 50. In a case in which these members are assembled, a through hole for placing the conductive portion 50 is formed. It is preferable that at least a portion of the conductive portion 50 is made of metal. In a case in which the conductive portion 50 penetrating in the thickness direction is made of metal, a strength of the cooling structure 100 in the thickness direction may be increased.

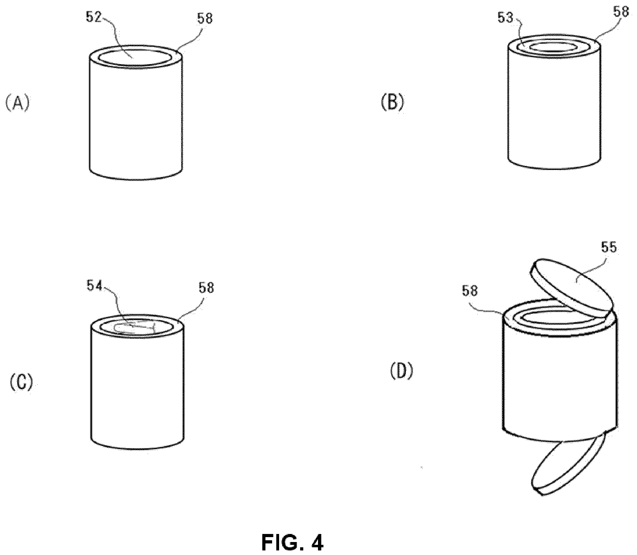

FIG. 4 is a schematic perspective view showing an example of the conductive portion 50.

In the conductive portion 50 in FIG. 4(A), an insulating layer 58 is arranged around a central member 52 made of metal. A shape of the central member 52 is not limited to a cylinder, and may be a prism, a cone, a pyramid, or the like.

In the conductive portion 50 in FIG. 4(B), an insulating layer 58 is arranged around a cylindrical central member 53 made of metal. The conductive portion 50 in FIG. 4(B) has a hollow axial center.

A height of both the central member 52 in FIG. 4(A) and the central member 53 in FIG. 4(B) is adjusted so as to penetrate the cooling structure in a thickness direction.

The conductive portion 50 may have an elastic structure. In a case in which the conductive portion 50 has an elastic structure, even if at least one of the cooling structure and the object to be cooled swells and shrinks due to heating and cooling, the conductive portion 50 maintains contact with the object to be cooled, and an electric conduction in the thickness direction of the cooling structure may be maintained. In addition, even if the cooling structure is deformed by a deformation other than swelling and shrinking, for example, deformation due to an external force, an electric conduction in the thickness direction of the cooling structure may be maintained.

An example of the conductive portion 50 having an elastic structure is shown in FIG. 4(C) and (D).

In the conductive portion 50 in FIG. 4(C), a spring-like central member 54 made of metal is arranged inside the hollow of a cylindrical insulating layer 58.

In FIG. 4(D), the cylindrical central member 53 shown in FIG. 4(B) is provided with a spring-like member 55 made of metal. The spring-like member 55 may be formed integrally with the cylindrical central member 53, or the spring member may be attached to the cylindrical central member 53.

In a case in which the conductive portion 50 has spring properties as in FIG. 4(C) and (D), it may be omitted to place a thermally conductive material (TIM) between the conductive portion 50 and the object to be cooled. In a case in which the conductive portion 50 does not have spring properties as in FIG. 4(A) and (B), it is preferable to place a TIM between the conductive portion 50 and the object to be cooled. Any known TIM may be used as appropriate, and a shape thereof may be any of a sheet, grease or the like.

The conductive portion 50 may be formed integrally with other components, or may be inserted to disposed later.

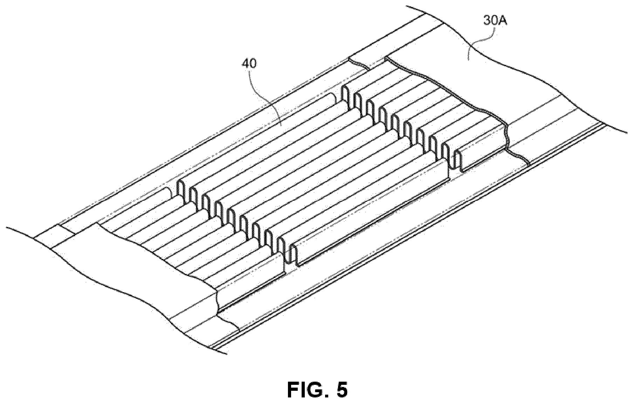

FIG. 5 is a schematic perspective view of the inner core material 40 in another embodiment in the present disclosure. As shown in FIG. 5, the inner core material 40 may be separated into two or more in the length direction. In this case, the conductive portion 50 may be provided at a separation position of the inner core material 40. Also, the conductive portion 50 may be provided at a position other than the separation position of the inner core material 40.

The outer packaging material 30 has a metal layer and a resin layer provided on at least one side of the metal layer. By providing a resin layer on an inside surface of the outer packaging material 30, an occurrence of corrosion due to the refrigerant is easily suppressed. Whereas, by providing a resin layer on an outside surface of the outer packaging material 30, insulation may be achieved. It is preferable that the outer packaging material 30 has resin layers provided on both sides of the metal layer. The lower outer packaging material 30A and the upper outer packaging material 30B may be made of the same material or different materials.

Examples of the metal layer include aluminum foil, stainless steel foil, nickel foil, plated copper foil, and clad metal of nickel foil and copper foil. From the viewpoint of thermal conductivity, cost or the like, aluminum foil is preferable.

A thickness of the metal layer is preferably 4 µm or more, and more preferably 8 µm or more. The thickness of the metal layer is preferably 300 µm or less, and more preferably 150 µm or less.

The resin layer is preferably composed of a resin having thermal fusion property, and examples of the resin include a polyolefin resin such as polyethylene, polypropylene or modified resins thereof, a fluorine-based resin, a polyester resin such as PET resin, and vinyl chloride resin.

A thickness of the resin layer is preferably 4 µm or more, and more preferably 8 µm or more. The thickness of the resin layer is preferably 300 µm or less, and more preferably 150 µm or less.

The metal layer and the resin layer may be laminated to form a laminate material. Another layer may or may not be provided between the metal layer and the inner resin layer.

A coating layer may be provided on the outermost layer of the laminate material. By providing the coating layer on the outer packaging material 30, a corrosion of the metal layer is prevented, and damage due to external and internal pressure tends to be prevented. In addition, in a case in which an insulating resin is used for the coating layer, it tends to be possible to impart effects such as preventing short circuits and electric leakage to the object to be cooled. Whereas, in a case in which a conductive resin is used for the coating layer, it tends to be possible to impart an antistatic effect to the object to be cooled.

As the resin for the coating layer, the same resin as that for the resin layer described above may be used. The coating layer may be made of the same material as the resin layer, or a different material. From the viewpoint of heat-sealing the resin layer of the outer packaging material 30 and the inner core material 40 while not requiring the coating layer to be heat-sealed, it is preferable to use a coating layer having a higher melting point than the resin layer, and it is particularly preferable to use a resin having a melting point 10°C or more higher.

A thickness of the coating layer is not particularly limited, and it is preferable to set it to the same thickness as the resin layer or thinner than the resin layer.

A thickness of the outer packaging material 30 is not particularly limited. From the viewpoint of strength and thermal conductivity, it is preferable that the thickness of the outer packaging material 30 is 8 µm or more, more preferably 10 µm or more, and even more preferably 12 µm or more. From the viewpoint of thinning and deformability, it is preferable that the thickness of the outer packaging material 30 is 300 µm or less, more preferably 250 µm or less, and even more preferably 200 µm or less. From these viewpoints, the thickness of the outer packaging material 30 is preferably from 8 µm to 300 µm, more preferably from 10 µm to 250 µm, and even more preferably from 12 µm to 200 µm.

The laminate material may be produced by attaching a resin film to a metal foil or metal plate. The resin film may be a stretched film or a non-stretched film. An adhesive may be used for attachment.

A material of the inner core material 40 is not particularly limited, and may be a resin, a metal or the like, or may be a laminate material in which a metal layer and a resin layer are laminated. The inner core material 40 may have a metal layer and resin layers provided on both sides of the metal layer. In a case in which the surface of the inner core material 40 is made of resin, it may be fused to the outer packaging material 30. Furthermore, in a case in which the surface of the inner core material 40 is made of resin, an occurrence of corrosion due to the refrigerant is more easily suppressed.

The metal layer of the inner core material 40 may suitably be the same as the metal layer of the outer packaging material 30. The metal layer of the laminate material as the inner core material 40 may be made of the same material as the metal layer of the laminate material as the outer packaging material 30, or may be made of a different material.

The resin layer of the laminate material as the inner core material 40 may suitably be the same material as the resin layer of the laminate material as the outer packaging material 30. From the viewpoint of thermally fusing the inner core material 40 to the outer packaging material 30, it is preferable that the resin layer of the laminate material as the inner core material 40 and the resin layer of the laminate material as the outer packaging material 30 are made of the same material.

The laminate material as the inner core material 40 may be produced by attaching a resin film to a metal foil or metal plate. The resin film may be a stretched film or a non-stretched film. An adhesive may be used for attachment.

The concave and convex shape of the inner core material 40 may be formed into a corrugated shape by pressing, pleating or the like. It may not only be a corrugated shape, but also an embossed shape with concave and convex portions distributed like a houndstooth pattern.

The pressing may be a discontinuous press or a continuous press. Examples of the discontinuous press include a forming method using an upper plate and a lower plate, and Examples of the continuous press include a roll forming method. Examples of the roll forming method include a corrugated processing method.

In the forming method using an upper plate and a lower plate, each of the upper plate and the lower plate is formed so that the concave and convex portions are arranged alternately. Each concave portion of the upper plate corresponds to each convex portion of the lower plate, and each convex portion of the upper plate corresponds to each concave portion of the lower plate, and the upper plate and the lower plate are configured so that the concave and convex portions of each plate interlock with each other. The inner core before processing may be formed into a corrugated shape by sandwiching and pressing the inner core between the upper plate and the lower plate.

The corrugated processing method may be performed using a pair of corrugated rolls. Each corrugated roll is formed so that concave and convex portions are arranged alternately along a rotational direction on its outer circumferential surface. Each concave portion of one corrugated roll corresponds to each convex portion of the other corrugated roll, and each convex portion of one corrugated roll corresponds to each concave portion of the other corrugated roll, and the pair of corrugated rolls are configured so that their concave and convex portions interlock with each other. Then, by sandwiching the inner core material before processing between the pair of corrugated rolls and rotating them, the inner core material may be passed between the pair of corrugated rolls and formed into a corrugated sheet shape.

In a case in which embossing is performed in the roll forming method, a pair of embossing rolls may be used. For example, an embossing rolls are used, in which concave and convex portions of the embossing rolls are arranged alternately on the outer circumferential surface along a rotational direction and an axial direction. Furthermore, the pair of embossing rolls are arranged so that the concave portions of one embossing roll correspond to the convex portions of the other embossing roll, and the convex portions of one embossing roll correspond to the concave portions of the other embossing roll, so that the pair of embossing rolls are arranged so that the concave and convex portions interlock with each other. Then, the inner core material before processing is sandwiched between the pair of embossing rolls and rotated, and the inner core laminate material is passed between the pair of embossing rolls to process the concave and convex portions. This way makes it possible to produce an embossed inner core material with concave and convex portions distributed like a houndstooth pattern or the like.

In the continuous press processing, the inner core material processed with the concave and convex portions is cut to a predetermined length by a shear knife (shear cutting blade) or the like provided downstream of the processing device to form the inner core material 40. In the continuous press processing, the process may be performed continuously by roll-to-roll, and the production efficiency may be improved.

In a case in which the inner core material 40 is made of resin, the concave and convex shape may be formed by vacuum molding.

A cross-sectional shape of the refrigerant flow path partitioned by the concave and convex shape of the inner core material 40 may be a semicircle, a semi-ellipse, a polygonal shape such as a triangle, a rectangle or a pentagon, an irregular shape, or a combination of these.

The multiple concave and convex shape may be arranged regularly or irregularly. Examples of an irregular arrangement include one in which the period of the concave portion and convex portion is not uniform. In the case of a regular arrangement, the period of the concave portions and the period of the convex portions may be the same or different.

In a case in which the cross-sectional shape of the refrigerant flow path is uniform, it is preferable to process the inner core material by continuous press processing from the viewpoint of production efficiency. In a case in which it is not uniform, it is preferable to process the inner core material by discontinuous press processing.

A refrigerant flows through the flow path that is partitioned into multiple parts by the concave and convex shape of the inner core material 40. A kind of the refrigerant is not particularly limited. Examples of the refrigerant include liquids such as water and organic solvents, and gases such as air. The water used as the refrigerant may contain components such as antifreeze.

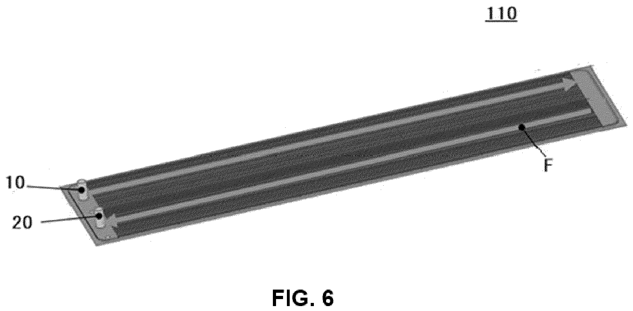

FIG. 6 is a schematic perspective view illustrating a modified example of the cooling structure, showing an interior in a case in which the upper outer packaging material 30B is removed.

In the cooling structure 100 of FIG. 1 and FIG. 2, the inlet 10 and outlet 20 for the refrigerant are provided at each end (front end, rear end) in the length direction. In contrast, in the cooling structure 110 of FIG. 6, both the inlet 10 and the outlet 20 are provided at one end. In the cooling structure 110 of FIG. 6, a joint pipe for the inlet 10 and a joint pipe for the outlet 20 are provided in the header section 12.

In the cooling structure 110 of FIG. 6, as shown by the arrow F in the figure, the refrigerant that flows from the inlet 10 of the header part 12 makes a U-turn at the footer part 22, reverses direction, and returns to the outlet 20 of the header section 12.

In FIG. 6, the refrigerant makes one round trip in the length direction, but it may make one and a half round trips. In this case, the header part 12 may be provided with an inlet 10, and the footer part 22 may be provided with an outlet 20. A number of times the refrigerant travels back and forth may be further increased.

In a case in which the refrigerant travels back and forth in the length direction, it is preferable to provide a partition between the forward flow path and the return flow path.

In yet another embodiment, there may be two or more inlets 10 and outlets 20, rather than just one each.

The cooling structure in the present disclosure may be widely used to cool heat-generating bodies, and is effective for cooling, for example, electronic devices such as smartphones and personal computers, battery modules mounted on electric vehicles, hybrid vehicles or the like, and power semiconductor modules.

### <Structure>

The structure in the present disclosure includes the cooling structure in the present disclosure described above, and an object to be cooled provided on the cooling structure.

Examples of the object to be cooled include heat-generating electronic devices such as smartphones and personal computers, battery modules mounted on electric vehicles and hybrid vehicles or the like, and power semiconductor modules.

The object to be cooled may be provided on either the outer packaging material 30B side or the outer packaging material 30A side of the cooling structure 100, or may be provided on both sides.

The present disclosure of Japanese Patent Application No. 2022-080412 is incorporated herein by reference in their entirety.

All documents, patent applications, and technical standards described in the present specification are incorporated herein by reference to the same extent as if each individual document, patent application, or technical standard were specifically and individually indicated to be incorporated by reference.

### Explanation of References

10 Inlet for refrigerant
20 Outlet for refrigerant
30, 30A, 30B Outer packaging material
40 Inner core material
42 Convex portion
44 Concave portion
50 Conductive portion
52, 53, 54 Central member
55 Spring-like member
58 Insulating layer
100, 110 Cooling structure

## Claims

1. A cooling structure comprising an outer packaging material with an inlet and an outlet for a refrigerant,
wherein the outer packaging material comprises a metal layer, and a resin layer provided on at least one surface of the metal layer, and
wherein the cooling structure comprises a conductive portion that conducts in a thickness direction of the cooling structure, and a periphery of the conductive portion is insulated.

2. The cooling structure according to claim 1, wherein the conductive portion comprises an elastic structure.

3. The cooling structure according to claim 1, wherein at least a part of the conductive portion is made of metal.

4. The cooling structure according to claim 1, further comprising an inner core material provided inside the outer packaging material.

5. The cooling structure according to claim 4, wherein the inner core material has a concave and convex shape that divide a flow path of the refrigerant into multiple parts.

6. The cooling structure according to claim 4, wherein the inner core material comprises a metal layer, and resin layers provided on both sides of the metal layer.

7. A structure comprising the cooling structure according to any one of claims 1 to 6 and an object to be cooled provided on the cooling structure.
